# EUROPÄISCHE PATENTSCHRIFT

(11) **EP 4 430 413 B1**
(45) Veröffentlichungstag und Bekanntmachung des Hinweises auf die Patenterteilung: **31.12.2025**
(21) Anmeldenummer: 22817610.3
(22) Anmeldetag: 11.11.2022
(51) Int. Cl.: G01R 31/392, G01R 31/367

(54) **BESTIMMUNG DES GESUNDHEITSZUSTANDS VON BATTERIEN MIT DYNAMISCHEM DIAGNOSE-BELASTUNGSPROFIL**
DETERMINING THE STATE OF HEALTH OF BATTERIES WITH DYNAMIC DIAGNOSTIC LOAD PROFILE
DÉTERMINATION DE L'ÉTAT DE BATTERIES AU MOYEN D'UN PROFIL DE CONTRAINTE DE DIAGNOSTIC DYNAMIQUE

(30) Priorität: 11.11.2021 DE 102021129351
(43) Veröffentlichungstag der Anmeldung: 18.09.2024
(73) Patentinhaber: TWAICE Technologies GmbH, 80807 München (DE)
(72) Erfinder: GRUBWINKLER, Stefan, 84036 Landshut (DE); KINK, Kilian, 85375 Neufahrn (DE); KEIL, Jonas, 80337 München (DE); BAUMANN, Michael, 80805 München (DE)
(74) Vertreter: Kraus & Lederer PartGmbB
(86) Internationale Anmeldenummer: PCT/EP2022/081584
(87) Internationale Veröffentlichungsnummer: WO 2023/084010

(56) Entgegenhaltungen:
- DE-A1- 102016 107 528
- FR-A1- 3 044 424
- US-A1- 2007 236 225

## Beschreibung

### TECHNISCHES GEBIET

Verschiedene Beispiele der Offenbarung betreffen Techniken, um den Gesundheitszustand von wiederaufladbaren Batterien zu bestimmen.

### HINTERGRUND

Elektrofahrzeuge verwenden wiederaufladbare Traktionsbatterien. Mit zunehmender Alterung, kann der Gesundheitszustand der Batterien abnehmen. Dies bewirkt eine Abnahme der Kapazität der Traktionsbatterien. Das beeinflusst die Zuverlässigkeit des Betriebs des Elektrofahrzeugs.

Deshalb kann es erstrebenswert sein, den Gesundheitszustand von Traktionsbatterien zu bestimmen. Dabei sind verschiedene Techniken zum Bestimmen des Gesundheitszustands bekannt. Solche Techniken erfassen Messdaten und bestimmen, basierend auf den Messdaten, den Gesundheitszustand. Viele dieser Techniken benötigen vergleichsweise lange Zeit, um eine entsprechende Diagnose abzuschließen.

Z.B. ist aus US2019170827A1 ein Verfahren bekannt, bei dem in der Praxis mindestens zwei komplette Ladevorgänge erforderlich sind. Bei Fahrzeugen ist zwischen zwei Ladevorgängen eine längere Fahrt notwendig, so dass sich aufgrund der Batteriegröße die Bestimmung des Gesundheitszustands über einen langen Zeitraum hinzieht.

Beispielsweise beschreibt Stroe, Daniel I., et al. "Diagnosis of lithium-ion batteries state-of-health based on electrochemical impedance spectroscopy technique." 2014 IEEE Energy Conversion Congress and Exposition (ECCE). IEEE, 2014 ein Labortechnisches Verfahren, welches die Verwendung von speziellem Messgerät zur Impedanzspektroskopie voraussetzt.

Zum Beispiel beschreibt US2019170827A1 ein Verfahren, um mittels wiederholter Messung der Spannung während eines Ladungsvorgangs und unter Verwendung eines Kalman-Filters den Gesundheitszustand (engl. state-of-health, SOH) zu bestimmen. Das Verfahren benötigt viele Messdaten und ist deshalb langsam.

CN201911402190.9A beschreibt ein Verfahren, das besonders schnell den SOH bestimmen soll. Es wurde aber beobachtet, dass die Genauigkeit des Verfahrens reduziert ist. Entsprechendes gilt für US 2007/0236225 A1.

FR 3 044 424 A1 offenbart eine tragbare Diagnosevorrichtung für eine Antriebsbatterie mit Messmitteln für Spannung, Strom, und Temperatur. Die Diagnosevorrichtung weist eine Steuereinheit auf, die ein Ladeprofil benutzt, um den Gesundheitszustand der Batterie und ihre Restlebensdauer zu bestimmen.

### KURZE ZUSAMMENFASSUNG

Deshalb besteht ein Bedarf für verbesserte Techniken, um den Gesundheitszustand von wiederaufladbaren Traktionsbatterien von Elektrofahrzeugen möglichst zügig und trotzdem genau zu bestimmen. Es besteht ein Bedarf für Techniken, die den Gesundheitszustand etwa für einen gesamten Batteriepack in Elektrofahrzeugen ohne aufwendiges Messgerät, wie z.B. bei der Impedanzspektroskopie, z.B. mit Hilfe einer in Werkstätten verfügbaren Kommunikationsschnittstelle, ermöglicht.

Diese Aufgabe wird gelöst von den Merkmalen der unabhängigen Patentansprüche.

Die Merkmale der abhängigen Patentansprüche definieren Ausführungsformen. Mittels der hierin beschriebenen Techniken ist die Bestimmung des Gesundheitszustands einer Traktionsbatterie eines Elektrofahrzeugs mit Hilfe eines Teilladevorgangs oder eines Teilentladevorgangs möglich. Dazu kann zum Beispiel ein Prüfstand verwendet, der mit einem Ladegerät ausgestattet ist. Es kann ein Diagnose-Belastungsprofil mit variablen Parametern verwendet werden. Dieses wird zum Laden bzw. Entladen der Traktionsbatterie verwendet. Messdaten, die während des Anwendens des Diagnose-Belastungsprofils beispielsweise von einem Batteriemanagementsystem (BMS) der Batterie erfasst werden, können über eine geeignete Fahrzeugschnittstelle (z.B. OBD2-Schnittstelle) mit einem Benutzerterminal (z.B. ein Rechner) erfasst und aufgezeichnet werden. Die Messdaten können in die Cloud an einen Server übertragen werden. Am Server kann dann aus den Messdaten mit Hilfe eines Schätzungsalgorithmus der Gesundheitszustand geschätzt werden.

Ein Computer-implementiertes Verfahren umfasst das Erhalten von Typdaten und von Zustandsdaten einer Traktionsbatterie eines Elektrofahrzeugs. Dabei ist die Traktionsbatterie an einen Prüfstand angeschlossen. Das Verfahren umfasst ferner das Bestimmen eine Diagnose-Belastungsprofils basierend auf den Typdaten sowie basierend auf den Zustandsdaten. Das Diagnose-Belastungsprofil umfasst mehrere Betriebsblöcke. Die mehreren Betriebsblöcke sind mit unterschiedlichen Belastungszenarien assoziiert. Außerdem umfasst das Computer-implementierte Verfahren auch das Ansteuern eines Prüfstands zum Anwenden des Diagnose-Belastungsprofils. Derart werden Messdaten für ein Spannungsprofil und für ein Stromprofil eines Belastungsvorgangs der Traktionsbatterie erhalten. Außerdem umfasst das Verfahren auch das Bestimmen einer Schätzung eines Gesundheitszustands der Traktionsbatterie basierend auf den Messdaten.

Ein Computerprogramm oder ein Computerprogramm-Produkt oder ein computerlesbares Speichermedium umfasst Programmcode. Der Programmcode kann von einem Prozessor geladen und ausgeführt werden. Das bewirkt, dass der Prozessor ein Verfahren ausführt. Das Verfahren umfasst das Erhalten von Typdaten und von Zustandsdaten einer Traktionsbatterie eines Elektrofahrzeugs. Dabei ist die Traktionsbatterie an einen Prüfstand angeschlossen. Das Verfahren umfasst ferner das Bestimmen eine Diagnose-Belastungsprofils basierend auf den Typdaten sowie basierend auf den Zustandsdaten. Das Diagnose-Belastungsprofil umfasst mehrere Betriebsblöcke. Die mehreren Betriebsblöcke sind mit unterschiedlichen Belastungszenarien assoziiert. Außerdem umfasst das Computer-implementierte Verfahren auch das Ansteuern eines Prüfstands zum Anwenden des Diagnose-Belastungsprofils. Derart werden Messdaten für ein Spannungsprofil und für ein Stromprofil eines Belastungsvorgangs der Traktionsbatterie erhalten. Außerdem umfasst das Verfahren auch das Bestimmen einer Schätzung eines Gesundheitszustands der Traktionsbatterie basierend auf den Messdaten.

Eine Vorrichtung umfasst einen Prozessor und einen Speicher. Der Prozessor kann Programmcode aus dem Speicher laden und ausführen. Das bewirkt, dass der Prozessor ein Verfahren ausführt. Das Verfahren umfasst das Erhalten von Typdaten und von Zustandsdaten einer Traktionsbatterie eines Elektrofahrzeugs. Dabei ist die Traktionsbatterie an einen Prüfstand angeschlossen. Das Verfahren umfasst ferner das Bestimmen eine Diagnose-Belastungsprofils basierend auf den Typdaten sowie basierend auf den Zustandsdaten. Das Diagnose-Belastungsprofil umfasst mehrere Betriebsblöcke. Die mehreren Betriebsblöcke sind mit unterschiedlichen Belastungszenarien assoziiert. Außerdem umfasst das Computer-implementierte Verfahren auch das Ansteuern eines Prüfstands zum Anwenden des Diagnose-Belastungsprofils. Derart werden Messdaten für ein Spannungsprofil und für ein Stromprofil eines Belastungsvorgangs der Traktionsbatterie erhalten. Außerdem umfasst das Verfahren auch das Bestimmen einer Schätzung eines Gesundheitszustands der Traktionsbatterie basierend auf den Messdaten.

Die oben dargelegten Merkmale und Merkmale, die nachfolgend beschrieben werden, können nicht nur in den entsprechenden explizit dargelegten Kombinationen verwendet werden, sondern auch in weiteren Kombinationen oder isoliert, ohne den Schutzumfang, der durch die Ansprüche definiert wird, der vorliegenden Erfindung zu verlassen.

### KURZE BESCHREIBUNG DER FIGUREN

FIG. 1 illustriert schematisch eine Vorrichtung zur Datenverarbeitung gemäß verschiedenen Beispielen.
FIG. 2 ist ein Flussdiagramm eines beispielhaften Verfahrens.
FIG. 3 ist ein Flussdiagramm eines beispielhaften Verfahrens.
FIG. 4 zeigt eine beispielhafte Referenz-Abhängigkeit eines Parameters eines Diagnose-Belastungsprofils von Zuständen einer Traktionsbatterie.
FIG. 5 ist ein Signalflussdiagramm, das die Kommunikation zwischen einem Prüfstand, einem Benutzerterminal, einem Server und einer Datenbank gemäß verschiedenen Beispielen illustriert.
FIG. 6 zeigt schematisch ein Diagnose-Belastungsprofil gemäß verschiedenen Beispielen.

### DETAILLIERTE BESCHREIBUNG

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Repräsentationen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und genereller Zweck dem Fachmann verständlich wird. In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein. Funktionale Einheiten können als Hardware, Software oder eine Kombination aus Hardware und Software implementiert werden.

Nachfolgend werden Techniken beschrieben, um einen Gesundheitszustand (engl. state of health) einer Batterie zu bestimmen. Der Gesundheitszustand kann z.B. einer Kapazität der Batterie entsprechen. Der Gesundheitszustand könnte auch einer Impedanz der Batterie entsprechen. Typischerweise nimmt mit fortschreitender Alterung einer Batterie die Kapazität der Batterie ab und die Impedanz der Batterie zu.

Die hierin beschriebenen Techniken ermöglichen eine besonders zügige und doch zuverlässige Bestimmung des Gesundheitszustands der Batterie. Die hierin beschriebenen Techniken benötigen keine aufwendigen Messgeräte.

Deshalb können die hierin beschriebenen Techniken insbesondere im Zusammenhang mit Traktionsbatterien von Elektrofahrzeugen eingesetzt werden, die an einen Prüfstand angeschlossen sind. Z.B. könnte bei einer technischen Eignungsprüfung des Elektrofahrzeugs an einem entsprechenden Prüfstand der Gesundheitszustand überprüft werden. Bei solchen Anwendungen ist es erforderlich, dass die Diagnosezeit (d.h. die Zeitspanne, die zum Erfassen der Messdaten benötigt wird, anhand derer die Schätzung des Gesundheitszustands bestimmt wird) nicht zu lange ist, um die pro Fahrzeug benötigte Zeit zu reduzieren.

Der Prüfstand kann die Batterien laden oder in manchen Beispielen auch entladen. Ein entsprechendes Diagnose-Belastungsprofil kann verwendet werden, um eine bestimmte Belastung im Rahmen des Ladens und/oder Entladens auf die Batterie auszuüben. Entsprechende Messdaten - die z.B. Spannungswerte und Stromwerte angeben - können dann erfasst werden und basierend auf den Messdaten kann eine Schätzung des Gesundheitszustands bestimmt werden.

Die Messdaten können also ein Spannungsprofil und ein Stromprofil umfassen, das heißt Spannungswerte als Funktion der Zeit und Stromwerte als Funktion der Zeit, jeweils während das Diagnose-Belastungsprofil angewendet wird.

Als allgemeine Regel wäre es denkbar, dass das Stromprofil und/oder das Spannungsprofil gemittelt über die verschiedenen Batteriezellen der Batterie bereitgestellt werden. Alternativ oder zusätzlich wäre es auch möglich, dass das Stromprofil und/oder das Spannungsprofil aufgelöst für verschiedene Batteriezellen bereitgestellt werden, das heißt jeweils Spannung und Strom in unterschiedlichen Batteriezellen indiziert wird. Derart könnte es möglich sein, Ungleichgewichte zwischen den verschiedenen Batteriezellen zu erkennen und den Gesundheitszustand der Batterie entsprechend zu kennzeichnen oder zu korrigieren.

Die Messdaten können alternativ oder zusätzlich zum Spannungsprofil bzw. zum Stromprofil auch andere Informationen beinhalten. Zum Beispiel könnten die Messdaten den Ladungszustand der Batterie angeben und/oder eine Betriebstemperatur der Batterie.

Die verwendeten Diagnose-Belastungsprofile können mehrere Betriebsblöcke aufweisen, die jeweils mit unterschiedlichen Belastungsszenarien der Batterie assoziiert sind.

Verschiedene Beispiele beruhen auf der Erkenntnis, dass durch die Verwendung unterschiedlicher Belastungsszenarien zwischen unterschiedlichen elektrochemischen Vorgängen in den Batteriezellen der Batterie unterschieden werden kann. Das Spannungsprofil und das Stromprofil können entsprechend charakteristische Merkmale für die elektrochemischen Vorgänge umfassen. Dadurch kann es möglich sein, die Schätzung des Gesundheitszustands unter Berücksichtigung der verschiedenen relevanten elektrochemischen Vorgänge (und damit besonders genau) zu bestimmen.

Einige Beispiele für Betriebsblöcke sind nachfolgend in TAB. 1 aufgeführt.

**TAB. 1: Verschiedene Beispiele für Betriebsblöcke, die zusammen ein Belastungsprofil bilden können. Außerdem sind Parameter angegeben, die einen entsprechenden Betriebsblock charakterisieren und in manchen Beispielen Typ-spezifisch und Zustands-spezifisch bestimmt werden können (Details hierzu werden später erläutert).**

| Betriebsblock | Erläuterung | Parameter |
|---|---|---|
| Ruhephase | Während der Ruhephase erfolgt kein Laden bzw. Entladen. Das bedeutet, dass kein Stromfluss auf die Batterie von außen aufgeprägt wird. | Dauer der Ruhephase |
| | Mittels der Ruhephase kann eine Ruhespannungsmessung vorbereitet werden. Das bedeutet, dass die Batterie in einem relaxierten Zustand sein kann, und dann z.B. ein Strompuls verwendet werden kann, um einen Wert für die Ruhespannung zu ermitteln. | |
| Strompuls | Hier können ein oder mehrere Strompulse verwendet werden, zum Beispiel zum sprunghaften Laden der Batterie. | - Zeitdauer zwischen Strompulsen |
| | | - Dauer / Anzahl der Strompulse |
| | Es könnte auch sprunghaft ein erhöhter Stromfluss zur Last gezogen werden. | |
| | | - Plateaudauer der Strompulse |
| | Durch die Verwendung von Strompulsen können Überspannungen bestimmt werden. Dazu kann das Zeitverhalten der Systemantwort abgeschätzt werden, d.h. z.B. ein Zeitversatz zwischen Strompuls und Spannungsänderung. | - Amplitude der Strompulse |
| Konstanter Stromfluss | In einem Betriebsblock mit konstantem Stromfluss kann ein endlicher Ladestrom oder Entladestrom mit konstanter Amplitude über einen ausgedehnten Zeitraum verwendet werden. | - Amplitude |
| | | - Dauer |
| | Die Ladekurve und Entladekurve bei Lithium-Speichern unterscheiden sich (Hysterese). | |
| | Durch die Verwendung des konstanten Stromflusses kann der Hysterese-Effekt kompensiert werden, so dass die Batteriespannung dem Wert auf der Lade- oder Entladekurve entspricht. | |
| | Außerdem kann durch das Laden mit konstanter Stromstärke eine gezielte Differenz von Ladungszuständen erzeugt werden. Dadurch kann ein bestimmter Ladungszustand eingestellt werden, indem die Batterie geladen wird oder entladen wird. | |
| Variabler Stromfluss | In einem solchen Betriebsblock kann mit einem Stromfluss der entweder größer oder kleiner als 0 ist kontinuierlich geladen oder entladen werden, wobei aber die Amplitude des Stromflusses variiert. Zum Beispiel könnte eine Amplitudenmodulation mit einem sinusförmigen, rechteckigen, dreieckigen oder sägezahnförmigen Amplitudenmodulationsmuster erfolgen. Es wären auch Kombinationen unterschiedlicher Muster, auch bei unterschiedlichen Frequenzen möglich. | - Amplitudenmodulationsmuster (Form, Frequenz, usw.) |
| | | - Dauer |
| | | - Amplitude |

Nachfolgend ist in TAB. 2 ein beispielhaftes Diagnose-Belastungsprofil wiedergegeben.

**TAB. 2: Ein beispielhaftes Diagnose-Belastungsprofil, das sich aus einer bestimmten Abfolge von Betriebsblöcken gemäß TAB. 1 zusammensetzt.**

| Phase | Betriebsblock | Erläuterung |
|---|---|---|
| I | Ruhephase | Messbeginn mit Ruhephase zur Bestimmung Ruhespannung des Batteriesystems und der einzelnen Zellen / Module |
| II | Konstanter Stromfluss | Laden mit konstanter Stromstärke zur Kompensation des Hysterese-Effekts |
| III | Strompuls | Mehrere Pulse mit dazwischenliegenden Ruhephasen zur Bestimmung auftretender Überspannungen, zur Auswertung der Zeitkonstanten der Impulsantwort |
| IV | Ruhephase | Bestimmung der Ruhespannung |
| V | Konstanter Stromfluss | SOC-Differenz zu Phase III |
| VI | Strompuls | Mehrere Pulse mit dazwischenliegenden Ruhephasen zur Bestimmung auftretender Überspannungen, zur Auswertung der Zeitkonstanten der Impulsantwort |
| VII | Ruhephase | Ruhephase zur Bestimmung Ruhespannung des Batteriesystems und der einzelnen Zellen / Module |

Verschiedene Beispiele beruhen ferner auf der Erkenntnis, dass die elektrochemischen Vorgänge (z.B. der Hysterese-Effekt, das Erreichen eines Ruhezustands, usw.) je nach Batterietyp und Zustand der Batterie auf unterschiedlichen Zeitskalen und/oder mit unterschiedlicher Stärke auftreten können. Für unterschiedliche Batterietypen verhalten sich die elektrochemischen Vorgänge unterschiedlich. Auch für Batterien einen desselben Batterietyps können unterschiedliche Zeitskalen und/oder Stärken der elektrochemischen Vorgänge beobachtet werden, je nach Zustand der Batterie, zum Beispiel je nach Temperatur oder Ladungszustand.

Um ausgehend von diesem Befund ein Diagnose-Belastungsprofil zu bestimmen, welches die Diagnosezeit minimiert und gleichzeitig ausreichend Messdaten erfasst, um den Gesundheitszustand zuverlässig zu bestimmen, wird das zu verwendende Diagnose-Belastungsprofil basierend auf Typdaten und basierend auf Zustandsdaten einer Traktionsbatterie eines Elektrofahrzeugs, welches an einen Prüfstand angeschlossen ist, bestimmt. Das bedeutet also, dass das Diagnose-Belastungsprofil Typ-spezifisch und Zustands-spezifisch bestimmt werden kann.

Die Typdaten sind dabei indikativ für einen Typ der Batterie. Beispielsweise könnten die Typdaten einen Hersteller, eine Herstellernummer, eine Seriennummer, usw. angeben. Die Typdaten könnten indikativ für eine Zellchemie der Batterie sein, z.B. ein Elektrodenmaterial spezifizieren. Die Typdaten könnten beispielsweise indikativ für eine Zellgeometrie sein. Die Typdaten könnten anzeigen, ob die Batterie über ein aktives Kühlsystem verfügt. Die Typdaten können in jedem Fall für die Lebenszeit der Batterie unveränderlich sein; das bedeutet, dass die Typdaten unabhängig von einem aktuellen Zustand der Batterie sein können.

Der Zustand der Batterie ändert sich über der Zeit. Der aktuelle Zustand der Batterie kann von den Zustandsdaten angezeigt werden. Beispielsweise könnten die Zustandsdaten indikativ für einen aktuellen Ladungszustand (engl. state of charge, SOC) der Batterie sein, d. h. z.B. die relative Ladung der Batterie in Bezug auf eine nominelle Kapazität der Batterie angeben. Die Zustandsdaten könnten indikativ für eine Betriebstemperatur der Batterie sein.

Indem das Diagnose-Belastungsprofil basierend auf den Typdaten und den Zustandsdaten ausgewählt wird, kann ein passendes Diagnose-Belastungsprofil ausgewählt werden. Das bedeutet, dass ein möglichst kurzes Diagnose-Belastungsprofil ausgewählt werden kann, das heißt mit einer möglichst kurzen Diagnosezeit. Trotzdem kann es mittels des passenden Diagnose-Belastungsprofils möglich sein, den Gesundheitszustand der Batterie möglichst genau zu bestimmen.

Basierend auf dem Diagnose-Belastungsprofil kann dann der Prüfstand zum Anwenden des Diagnose-Belastungsprofils angesteuert werden. Derart können die Messdaten erhalten werden. Basierend auf den Messdaten ist es dann möglich, die Schätzung des Gesundheitszustands zu bestimmen.

Als allgemeine Regel können zur Bestimmung der Schätzung des Gesundheitszustands unterschiedliche Techniken eingesetzt werden. Das bedeutet, dass unterschiedliche Typen von Schätzungsalgorithmen eingesetzt werden können. Beispielsweise wäre es denkbar, dass ein Schätzungsalgorithmus ein maschinengelerntes Modell umfasst. Beispiele für maschinengelernte Modelle wären zum Beispiel künstlichen neuronalen Netzwerke, Regressionsmodelle usw. Sh. zum Beispiel: Roman, Darius, et al. "Machine learning pipeline for battery state-of-health estimation." Nature Machine Intelligence 3.5 (2021): 447-456. Ein Beispiel für ein künstliches neuronales Netzwerk wäre zum Beispiel ein LSTM-Netzwerk (sh. z.B. Qu, Jiantao, et al. "A neural-network-based method for RUL prediction and SOH monitoring of lithium-ion battery." IEEE access 7 (2019): 87178-87191). Der Schätzungsalgorithmus muss aber nicht unbedingt ein maschinengelerntes Modell umfassen. Zum Beispiel könnten auch herkömmlich parametrisierte Modelle verwendet werden. Es könnten Filterverfahren eingesetzt werden, zum Beispiel ein Kalman-Filter oder ein Verfahren zum Anpassen von vor-definierten Abhängigkeiten. Beispielhafte Techniken sind z.B. beschrieben in: Andre, Dave, et al. "Advanced mathematical methods of SOC and SOH estimation for lithium-ion batteries." Journal of power sources 224 (2013): 20-27. in verschiedenen Beispielen kann ein einstufiger Schätzungsalgorithmus eingesetzt werden, der basierend auf den Messdaten direkt den Gesundheitszustand schätzt. Andererseits wäre es auch denkbar, dass in einer 1. Stufe ein oder mehrere Werte für ein oder mehrere Batterieparameter geschätzt werden (zum Beispiel um ein Ersatzschaltkreismodell zu parametrisieren). Dann kann in einer 2. Stufe anhand der ein oder mehreren Werte der Gesundheitszustand geschätzt werden. In einem solchen Szenario kann also eine Modellierung der Batterie mit einem physikalischen Modell, etwa einem Ersatzschaltkreismodell oder einem Wärmedissipationsmodell erfolgen. Sh. z.B. Chang, Fengqi, et al. "Modelling and evaluation of battery packs with different numbers of paralleled cells." World Electric Vehicle Journal 9.1 (2018): 8. Aus diesen Ausführungen ist ersichtlich: Der konkrete Schätzungsalgorithmus ist dabei nicht entscheidend für die hierin beschriebenen Techniken. Es können grundsätzlich bekannte Schätzungsalgorithmen verwendet werden.

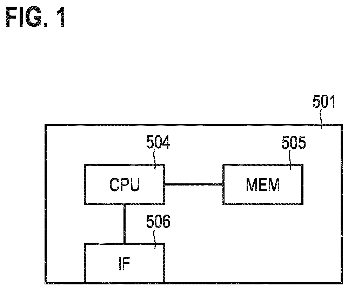

FIG. 1 illustriert schematisch eine Vorrichtung 501, die eingerichtet sein kann, um Techniken im Zusammenhang mit der Schätzung eines Gesundheitszustands durchzuführen, wie sie ihren beschrieben sind. Beispielsweise könnte die Vorrichtung 501 durch einen Computer implementiert werden. Die Vorrichtung 501 könnte durch einen Server implementiert werden.

Die Vorrichtung 501 umfasst einen Prozessor 504 sowie einen Speicher 505. Außerdem umfasst die Vorrichtung 501 auch eine Kommunikationsschnittstelle 506, über die der Prozessor 504 mit anderen Einheiten kommunizieren kann. Beispielsweise könnte der Prozessor 504 über die Kommunikationsschnittstelle 506 einen Prüfstand, den ein Elektrofahrzeug angeschlossen ist, ansteuern, so dass der Prüfstand ein Diagnose-Belastungsprofil anwendet. Der Prozessor 504 könnte über die Kommunikationsschnittstelle 506 Messdaten erhalten. Beispiele für solche Messdaten wären zum Beispiel insbesondere ein Spannungsprofil oder ein Stromprofil. Es könnten auch weitere Messdaten erhalten werden, zum Beispiel ein Profil betreffend den Ladungszustand, das heißt die Veränderung des Ladungszustands als Funktion der Zeit; und/oder ein Profil betreffend die Temperatur, das heißt die Betriebstemperatur der Batterie als Funktion der Zeit. Der Prozessor 504 kann Programmcode aus dem Speicher 505 laden und ausführen. Dies bewirkt, dass der Prozessor Techniken im Zusammenhang mit der Schätzung des Gesundheitszustands, wie hierin beschrieben, ausführt. Beispielsweise kann der Prozessor ein Diagnose-Belastungsprofil bestimmen, basierend auf Typdaten und Zustandsdaten einer Batterie. Der Prozessor kann außerdem den Gesundheitszustand der Batterie basierend auf Messdaten schätzen, zum Beispiel indem ein oder mehrere Schätzungsalgorithmen ausgeführt werden.

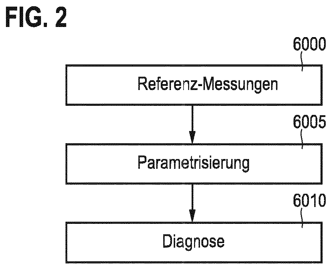

FIG. 2 illustriert ein Flussdiagramm gemäß verschiedenen Beispielen. Das Flussdiagramm aus FIG. 2 zeigt verschiedene Phasen im Zusammenhang mit der Vorbereitung und Verwendung eines Schätzungsalgorithmus, der zur Schätzung eines Gesundheitszustands verwendet wird. Fig. 2 zeigt außerdem verschiedene Aspekte im Zusammenhang mit der Vorbereitung der Bestimmung von Diagnose-Belastungsprofil in Abhängigkeit vom Zustand und vom Typ von Traktions-Batterien.

Zunächst werden in Box 6000 ein oder mehrere Referenz-Messungen durchgeführt. Die Referenz-Messungen können zur Charakterisierung von wiederaufladbaren Traktions-Batterien von Elektrofahrzeugen dienen. Die Referenz-Messungen können zum Beispiel bestimmte physikalisch-chemischen Eigenschaften der Traktions-Batterien quantifizieren. Es könnten zum Beispiel Referenz-Abhängigkeiten zwischen Parametern eines Diagnose-Belastungsprofil und unterschiedlichen Zuständen von Traktions-Batterien jeweils für unterschiedliche Typen von Traktions-Batterien bestimmt werden, z.B. anhand einer solchen Quantifizierung von physikalisch-chemischen Eigenschaften.

Beispiele für physikalisch-chemische Eigenschaften, die im Rahmen der Referenz-Messungen quantifiziert werden können, wären zum Beispiel: Hysteresespannung; Impuls-Antwort der Batterie; Ruhespannung. Solche physikalisch-chemischen Eigenschaften können zum Beispiel jeweils für unterschiedliche Zustände der Batterie bestimmt werden, das heißt zum Beispiel für unterschiedliche Ladungszustände oder unterschiedliche Betriebstemperaturen usw.

Es ist möglich, dass die Referenz-Messungen auch die Anwendung eines Referenz-Diagnose-Belastungsprofils umfassen. Derart können Trainings-Messdaten erhalten werden. Das Referenz-Diagnose-Belastungsprofil kann dann als Vorlage für ein Diagnose-Belastungsprofil dienen, welches während der Inferenz-Phase zum Erfassen von korrespondierenden Messdaten verwendet wird.

Mittels der Referenz-Messungen kann eine Grundwahrheit betreffend den Gesundheitszustand der Traktions-Batterien ermittelt werden. Das bedeutet, dass die Referenz-Messungen zur Bestimmung beispielsweise der Kapazität oder der Impedanz eingesetzt werden können. Dabei können die Referenz-Messungen verschieden sein von der Messung im Zusammenhang mit dem Anwenden des Diagnoseprofils; beispielsweise können im Zusammenhang mit der Referenz-Messung labortechnische Verfahren zur Ermittlung des Gesundheitszustands eingesetzt werden.

**In** Box 6005 erfolgt die Parametrisierung eines Schätzungsalgorithmus, der zur Bestimmung der Schätzung eines Gesundheitszustands von Traktions-Batterien verwendet werden kann. Dies kann auf den Referenz-Messungen basieren. Basierend auf den Referenz-Messungen können Trainings-Messdaten erhalten werden, die zur Parametrisierung des Schätzungsalgorithmus in Box 6005 verwendet werden. Basierend auf den Referenz-Messungen können auch Grundwahrheiten (engl. ground truth) für den Gesundheitszustand bestimmt werden. Beispielsweise könnte mittels der Referenz-Messungen der Gesundheitszustand einer Batterie ermittelt werden und entsprechenden Trainings-Messdaten zugeordnet werden. Zum Beispiel könnten die Referenz-Messungen in einem Labor durchgeführt werden. Typischerweise können solche Labormessungen den Gesundheitszustand von Batterien mit hoher Genauigkeit bestimmen, zum Beispiel mittels elektrischer Impedanzspektroskopie usw.

Box 6005 kann zum Beispiel ein Training für maschinengelernte Algorithmen umfassen. Zum Beispiel könnten Techniken der Rückwärtspropagation (Gradientenabstiegsverfahren) zur Bestimmung von Gewichten eines künstlichen neuronalen Netzwerks verwendet werden.

Es könnte auch ein händisches Parametrisieren erfolgen.

Unabhängig vom konkreten Modus der Parametrisierung kann in Box 6005 jeweils überprüft werden, dass die Ausgabe des Schätzungsalgorithmus (das heißt die Schätzung des Gesundheitszustands) möglichst gut mit der Grundwahrheit übereinstimmt.

Anschließend kann in Box 6010 eine Diagnose erfolgen. Das bedeutet, dass die Schätzung des Gesundheitszustands durchgeführt werden kann, ohne dass eine entsprechende Grundwahrheit verfügbar wäre. Box 6010 wird auch als Inferenz-Phase bezeichnet. Dazu kann auf ein oder mehrere Schätzungsalgorithmen zurückgegriffen werden, die in Box 6005 parametrisiert wurden.

Grundsätzlich wäre es denkbar, dass sowohl Box 6005, wie auch Box 6010 von einer Vorrichtung wie zum Beispiel Vorrichtung 501 (vergleiche FIG. 1) ausgeführt werden. Es wäre aber auch denkbar, dass unterschiedliche Vorrichtungen für das Ausführen von Box 6005 und Box 6010 verwendet werden.

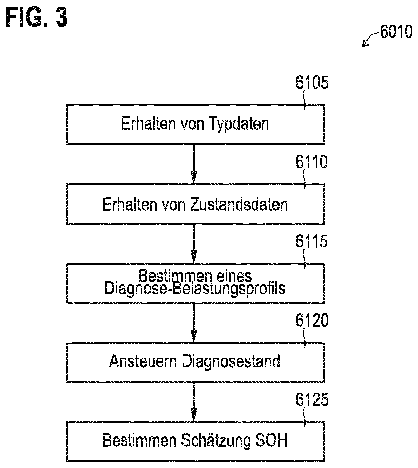

Als nächstes werden Details im Zusammenhang mit Box 6010 in FIG. 3 beschrieben. FIG. 3 ist ein Flussdiagramm eines beispielhaften Verfahrens. FIG. 3 ist ein Flussdiagramm eines Verfahrens zum Bestimmen einer Schätzung eines Gesundheitszustands einer Batterie. FIG. 3 betrifft die Inferenz-Phase; d.h. es sind bereits Regeln zum Bestimmen von Diagnose-Belastungsprofil in Abhängigkeit von Typdaten und Zustandsdaten bekannt, beispielsweise basierend auf den Referenz-Messungen aus Box 6000. Außerdem ist ein Schätzungsalgorithmus verfügbar, der parametrisiert ist und zur Bestimmung der Schätzung des Gesundheitszustands basierend auf Messdaten verwendet werden kann.

Zum Beispiel könnte das Verfahren aus FIG. 3 von der Vorrichtung 501 aus FIG. 1 ausgeführt werden. Insbesondere könnte das Verfahren von FIG. 3 von einem Server ausgeführt werden.

In Box 6105 werden Typdaten einer Traktionsbatterie eines Elektrofahrzeugs erhalten. Das Elektrofahrzeug ist an einen Prüfstand angeschlossen. Über eine Datenverbindung des Prüfstands mit der Traktionsbatterie (zum Beispiel mit einem Managementsystem der Traktionsbatterie) können die Typdaten ausgelesen werden oder Information ausgelesen werden, die indikativ für die Typdaten ist. Der Prüfstand kann dann die Typdaten an den Server übermitteln. Die Typdaten können einen Typ der Traktionsbatterie kennzeichnen. Bestimmte, nicht direkt vom Betrieb abhängige Typeigenschaften der Traktionsbatterie können durch die Typdaten indiziert werden, z.B. Seriennummer, Herstelleridentifikation, Zellgeometrie, Zellanzahl, usw.

In Box 6110 werden Zustandsdaten der Traktionsbatterie das Elektrofahrzeugs erhalten. Beispielsweise können die Zustandsdaten über die Datenverbindung zwischen dem Prüfstand und der Traktionsbatterie vom Managementsystem der Traktionsbatterie erhalten werden. Die Zustandsdaten können einen gegenwärtigen Zustand der Traktionsbatterie beschreiben. Beispielsweise könnten die Zustandsdaten den Ladungszustand der Traktionsbatterie beschreiben (das heißt den SOC angeben). Die Zustandsdaten könnten zum Beispiel eine Betriebstemperatur der Traktionsbatterie angeben.

In Box 6115 wird dann ein Diagnose-Belastungsprofil basierend auf den Typdaten und auch basierend auf den Zustandsdaten bestimmt. Das Diagnose-Belastungsprofil umfasst mehrere Betriebsblöcke, wobei die Betriebsblöcke mit unterschiedlichen Belastungsszenarien assoziiert sind. Beispielhafte Betriebsblöcke wurden obenstehend im Zusammenhang mit TAB. 1 beschrieben. Ein beispielhaftes Diagnose-Belastungsprofil wurde in TAB. 2 erläutert.

Das bedeutet also, dass das Diagnose-Belastungsprofil spezifisch angepasst auf den jeweiligen Typ der Traktionsbatterie sein kann und außerdem spezifisch angepasst auf den jeweiligen Zustand der Traktionsbatterie sein kann. Dadurch wird ermöglicht, dass einerseits ein besonders kurzes Diagnose-Belastungsprofil bestimmt werden kann - das bedeutet, dass das Diagnose-Belastungsprofil möglichst wenig Betriebsblöcke umfassen kann und/oder die Betriebsblöcke besonders kurz ausgebildet sind. Gleichzeitig kann durch die individuelle Abstimmung des Diagnose-Belastungsprofils auf Typ und Zustand der Batterie der Gesundheitszustand besonders genau ermittelt werden.

Das Diagnose-Belastungsprofil kann basierend auf Referenz-Abhängigkeiten zwischen Parametern des Diagnose-Belastungsprofils und den Zustandsdaten und/oder den Typdaten bestimmt werden. Solche Referenz-Abhängigkeiten können basierend auf den Referenz-Messungen (vergleiche Fig. 2: Box 6000) bestimmt werden.

Das Diagnose-Belastungsprofil kann so bestimmt werden, dass die Diagnosezeit minimiert wird. Allgemein formuliert kann das Diagnose-Belastungsprofil unter Berücksichtigung der Zeitdauer des Diagnose-Belastungsprofils bestimmt werden.

Das Diagnose-Belastungsprofil kann so bestimmt werden, dass die Genauigkeit der Schätzung des Gesundheitszustands maximiert wird. Allgemein formuliert kann das Diagnose-Belastungsprofil unter Berücksichtigung der Genauigkeit der Schätzung des Gesundheitszustands bestimmt werden.

In Box 6120 wird dann der Prüfstand angesteuert, um das Diagnose-Belastungsprofil anzuwenden. Entsprechende Information wird aus Box 6115 erhalten. Dazu können zum Beispiel bestimmte Parameter an den Prüfstand übermittelt werden, beispielsweise eine Abfolge von Betriebsblöcken und entsprechende Parameterwerte für Eigenschaften der Betriebsblöcke, etwa Dauer, Stromamplituden, usw. Wenn bereits unterschiedliche Kandidaten-Diagnose-Belastungsprofile am Prüfstand hinterlegt sind, können auch ein Index des zu aktivierenden Kandidaten-Diagnose-Belastungsprofils an den Prüfstand übermittelt werden.

Dann werden im Zusammenhang mit dem Ansteuern des Prüfstands auch entsprechend Messdaten erhalten, die das Spannungsprofil und das Stromprofil des Belastungsvorgangs der Traktionsbatterie, der mit dem Diagnose-Belastungsprofil assoziiertes, zu erhalten. Alternativ oder zusätzlich zum Spannungsprofil und dem Stromprofil könnten auch ein Profil der Betriebstemperatur und/oder ein Profil des Ladungszustands erhalten werden. Die Messdaten können von einem Managementsystem der Batterie erzeugt werden und an den Prüfstand übermittelt werden.

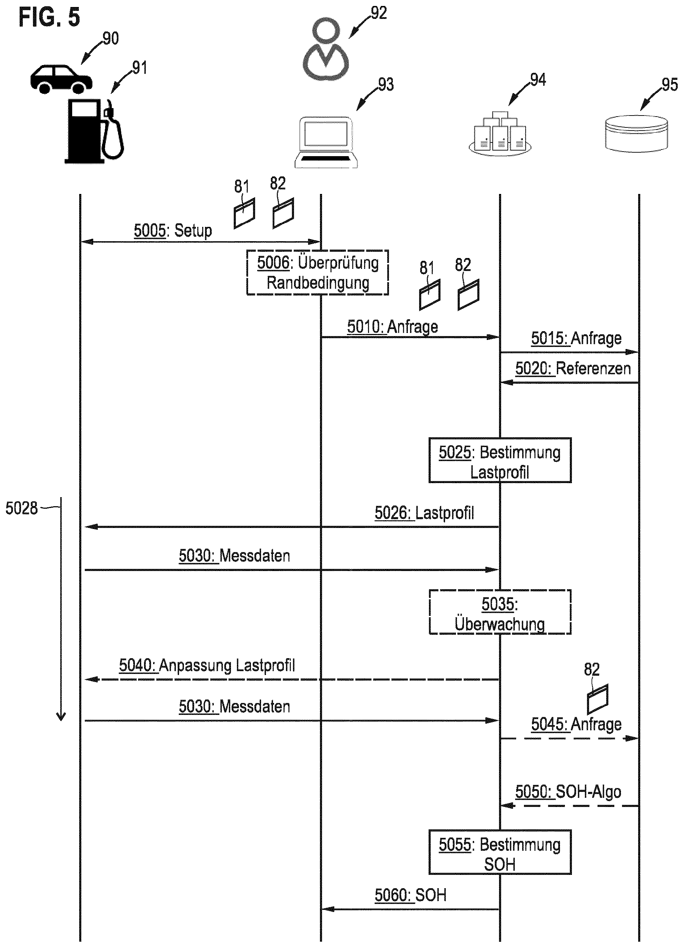

In manchen Beispielen können die Messdaten kontinuierlich erhalten werden, das heißt während des Anwendens des Diagnose-Belastungsprofils. In anderen Beispielen wäre es auch denkbar, dass die Messdaten erst nach Abschluss des Diagnose-Belastungsprofils erhalten werden. Wenn die Messdaten kontinuierlich erhalten werden, wäre es denkbar, dass ein Anpassen des Diagnose-Belastungsprofil vor Ende der Diagnosezeit erfolgt, das heißt es könnte direkt auf bestimmte Signaturen in den Messdaten reagiert werden und das Diagnose-Belastungsprofil zum Beispiel verkürzt oder verlängert werden. Entsprechend Aspekte werden später im Zusammenhang mit Fig. 5: Box 5035 erläutert.

Basierend auf solchen Messdaten kann dann in Box 6125 die Schätzung des Gesundheitszustands der Traktionsbatterie bestimmt werden. Dazu können ein oder mehrere Schätzungsalgorithmen verwendet werden, die zuvor parametrisiert wurden (vergleiche FIG. 2: Box 6005).

Wie obenstehend erläutert, kann zum Bestimmen des Diagnose-Belastungsprofils auf ein vordefiniertes Regelwerk zurückgegriffen werden. Das vordefinierte Regelwerk könnte, in einer einfachen Variante, durch Expertenwissen festgelegt werden. Zwei weitere Beispiele sind in TAB. 3 dargelegt.

**TAB. 3: Zwei beispielhafte Strategien, um das Diagnose-Belastungsprofil zu bestimmen.**

| | |
|---|---|
| Wie wird das Regelwerk zur Bestimmung des Diagnose-Belastungsprofils bestimmt? | Erläuterung |
| Gemäß Parametrisierung des Schätzungsalgorithmus | Das Regelwerk kann im Zusammenhang mit der Parametrisierung des Schätzungsalgorithmus, vergleiche FIG. 2: Box 6005, erhalten werden. Zur Parametrisierung des Schätzungsalgorithmus können nämlich Trainings-Messdaten verwendet werden, die basierend auf einem Referenz-Diagnose-Belastungsprofil erfasst werden. Es kann dann ein Diagnose-Belastungsprofil verwendet werden, welches möglichst ähnlich dem Referenz-Diagnose-Belastungsprofil ist. Das bedeutet, dass in der Inferenz-Phase möglichst genau die Referenz-Messung nachgestellt wird. |
| | Das bedeutet also, dass eine Abhängigkeit zwischen Parametern des Diagnose-Belastungsprofils und den Zustandsdaten und den Typdaten so gewählt sein kann, dass das Diagnose-Belastungsprofil möglichst gut mit dem Referenz-Diagnose-Belastungsprofil übereinstimmt, das zum Erfassen der Trainings-Messdaten verwendet wurde, mit denen der Schätzungsalgorithmus parametrisiert wurde. |
| | Solche Techniken beruhen auf der Erkenntnis, dass die Parametrisierung des Schätzungsalgorithmus auf ein bestimmtes Messszenario angepasst ist und dass eine Reproduktion des Messszenario typischerweise besonders genaue Ergebnisse ermöglicht. Dies ist insbesondere zutreffend für maschinengelernte Modelle, beispielsweise künstliche neuronale Netzwerke. |
| | Bei maschinengelernten Modellen ist die Genauigkeit der Vorhersage besonders hoch, wenn die Eingangsdaten während der Inferenz vergleichbar zu den Eingangsdaten während des Trainings sind. |
| Anhand von chemisch-physikalischen Eigenschaften der Batterie | Das Regelwerk kann basierend auf physikalisch-chemischen Eigenschaften der Batterie bestimmt werden, wobei diese chemisch-physikalischen Eigenschaften z.B. anhand der Referenz-Messungen oder basierend auf Literaturwissen bestimmt werden. |
| | Beispielsweise können mittels Referenz-Messungen grundlegende Abhängigkeiten zwischen physikalisch-chemischen Zuständen der Batterie erfasst werden. |
| | Ein solcher Ansatz weist den Vorteil auf, dass auch Aussagen über Bereiche der Zustandsdaten oder der Typdaten getroffen werden können, für die keine Referenz-Messungen erfasst wurden. Das bedeutet, dass zum Beispiel interpoliert werden kann, um für eine bestimmten Wert der Zustandsdaten ein geeignetes Diagnose-Belastungsprofil zu bestimmen. |
| | Beispielsweise könnte anhand von Referenz-Messungen festgestellt werden, dass für einen bestimmten Batterietyp eine besonders starke Hysteresespannung vorliegt. Dann kann es erforderlich sein, dass Diagnose-Belastungsprofil entsprechend auszubilden, um die starke Hysteresespannung zu kompensieren. Dies kann eine für diesen Batterietyp verlängerte Diagnosezeit bedingen. Für einen anderen Batterietyp kann aber keine entsprechend starke Hysteresespannung vorliegen und für einen solchen Batterietyp kann dann die Diagnosezeit reduziert werden. Anhand der Referenz-Messungen kann außerdem eine Parametrisierung des Schätzungsalgorithmus (vgl. FIG. 2: Box 6005) erfolgen. |

Nachfolgend werden konkrete Implementierungen der Strategien aus TAB. 3 beschrieben.

Beispielsweise wäre es denkbar, dass die Betriebsblöcke des Diagnose-Belastungsprofil es aus einer Vielzahl von vordefinierten Betriebsblöcken ausgewählt werden. Das bedeutet also, dass im Baukasten-Prinzip unterschiedliche Betriebsblöcke, die jeweils vor definiert sind, zusammengesetzt werden können, um der das Diagnose-Belastungsprofil zu bilden.

Dies weist den Vorteil auf, dass individuelle Parameter der verschiedenen Betriebsblöcke vorgegeben sein können, und lediglich die vordefinierten Betriebsblöcke aneinandergereiht werden können. Insbesondere können vordefinierte Betriebsblöcke verwendet werden, für welche bereits bei der Parametrisierung des Schätzungsalgorithmus (vergleiche FIG. 2: Box 6005) Trainings-Messdaten erfasst wurden. In anderen Worten können also bei der eigentlichen Diagnose in Box 6010 und der Parametrisierung in Box 6005 vergleichbare Belastungsszenarien angewendet werden. Dadurch kann eine hohe Genauigkeit im Zusammenhang mit der Bestimmung des Gesundheitszustands erzielt werden, trotzdem kann auf unterschiedliche Randbedingungen, beispielsweise Batterien von unterschiedlichen Typen oder in unterschiedlichen Zuständen, eingegangen werden.

Neben einer Auswahl der verschiedenen Betriebsblöcke kann das Bestimmen des Diagnose-Belastungsprofils gemäß TAB. 3: Szenario 1 außerdem das Bestimmen der Abfolge der mehreren Betriebsblöcke umfassen. Das bedeutet in anderen Worten, dass die Sequenz und/oder die Anzahl, mit der unterschiedliche Betriebsblöcke im Diagnose-Belastungsprofil verwendet werden, variiert werden kann.

Es kann auch das Parametrisieren von ein oder mehreren Parametern von mindestens einem Betriebsblock der mehreren Betriebsblöcke möglich sein. Beispielsweise wurden im Zusammenhang mit TAB. 1 obenstehend verschiedene Parameter für die unterschiedlichen Betriebsblöcke dargelegt. Solche Parameter können also zum Beispiel betreffen: Dauer des entsprechenden Betriebsblocks; Entladungsrate oder Laderate (auch als C-Rate bezeichnet) eines entsprechenden Entladungsstroms oder Ladestroms; Amplitude von Strompulsen; usw.

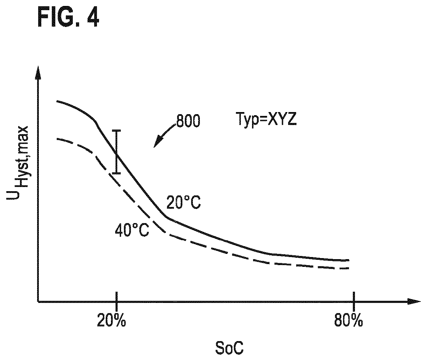

Als nächstes wird im Zusammenhang mit FIG. 4 eine vorgegebene Referenz-Abhängigkeit erläutert, die beim Bestimmen des Diagnose-Belastungsprofils berücksichtigt werden kann. Zum Beispiel wäre es möglich, basierend auf einer solchen Abhängigkeit ein oder mehrere Parameter des mindestens einen Betriebsblocks zu parametrisieren.

In FIG. 4 ist eine Abhängigkeit 800 der maximal möglichen Hysteresespannung vom Ladungszustand der Batterie für einen bestimmten Batterietyp dargestellt. Diese Abhängigkeit 800 kennzeichnet eine chemisch-physikalische Eigenschaft des jeweiligen Batterietyps. Diese Abhängigkeit 800 ist für mehrere Temperaturen dargestellt (durchgezogene und gestrichelte Linie).

Die maximal mögliche Hysteresespannung beeinflusst die Zeitdauer, die benötigt wird, die Ruhespannungskennlinie in Laderichtung zu erreichen.

Die maximal mögliche Hysteresespannung ist deshalb direkt proportional zu einer Zeitdauer eines Betriebsblocks des Diagnose-Belastungsprofils mit konstantem Stromfluss (vgl. TAB. 1). Deshalb zeigt FIG. 4 eine Abhängigkeit zwischen dem entsprechenden Parameter des Diagnose-Belastungsprofils und den entsprechenden Zustandsdaten (SOC, Temperatur) und Typdaten (Batterietyp "XYZ").

In FIG. 4 ist also dargestellt, dass für größere Temperaturen kleinere maximale Hysteresespannungen erwartet werden, und damit auch die Zeitdauer zum Erreichen dieser maximalen Spannung reduziert werden kann. Außerdem ist in FIG. 4 dargestellt, dass für größere Ladungszustände kleinere maximale Hysteresespannungen erwartet werden, damit also auch die Zeitdauer zum Erreichen der Zielspannung reduziert werden kann. Das bedeutet also, dass je nach Ladungszustand und Temperatur einer Batterie entsprechenden Typs - der Ladungszustand und die Temperatur werden über die Zustandsdaten bereitgestellt - und unter Berücksichtigung der Abhängigkeit aus FIG. 4, die Dauer der Ladephase mit konstantem Stromfluss angepasst werden kann.

In FIG. 4 ist nur ein Beispiel für eine Abhängigkeit zwischen Parametern des Diagnose-Belastungsprofils und Zustands- bzw. Typdaten dargestellt. Weitere Beispiele für solche Abhängigkeiten sind nachfolgend in TAB. 4 zusammengefasst.

**TAB. 4: Verschiedene Beispiele für Abhängigkeiten zwischen Parametern (genauer: Parameterwerten) des Diagnose-Belastungsprofils und Zustandsdaten; diese Abhängigkeiten sind jeweils verschieden für verschiedene Batterien. Als allgemeine Regel können solche vorgegebenen Abhängigkeiten basierend auf Referenz-Messungen bestimmt werden (vgl. Box 6000 in FIG. 2). Die unterschiedlichen Beispiele können jeweils individuell oder in Kombination berücksichtigt werden.**

| Abhängigkeit | Details |
|---|---|
| Hysteresespannung / Dauer Ladephase - Ladungszustand, Batterietyp und/oder Temperatur (vgl. FIG. 4) | Bei der Änderung des Ladungszustands kann eine bestimmte Hysteresespannung auftreten. Diese Hysteresespannung kann bewirken, dass eine anschließende Messung der Ruhespannung verfälscht wird. Entsprechend kann es erforderlich sein, eine Kompensation der Hysteresespannung vorzusehen. |
| | Diese Hysteresespannung unterscheidet sich je nach Batteriertyp. Dabei ändert sich die Hysteresespannung je nach Ladezustand der Batterie. Zudem ändert sich die Hysteresespannung je nach Zelltemperatur. |
| | Durch Berücksichtigung dieser Abhängigkeit kann die Diagnosezeit so lang wie nötig, aber so kurz wie möglich gewählt werden. |
| Ladungszustand-Differenz - Batterietyp | Je nach Batterietyp kann es erforderlich sein, einen unterschiedlichen Offset zwischen den Ladungszuständen vorzusehen. Um signifikante Ergebnisse zu erhalten, kann es bei manchen Batterietypen ausreichend sein, einen vergleichsweise geringen Offset, zum Beispiel von 5 Prozentpunkten, zu verwenden; während bei anderen Batterietypen ein größerer Offset zwischen den Ladungszuständen notwendig ist. Entsprechend kann dann eine Ladephase verkürzt oder verlängert werden. |
| Dynamische Reaktion - Batterietyp, Ladungszustand und/oder Temperatur | Wie zum Beispiel obenstehend im Zusammenhang mit TAB. 2 diskutiert, kann eine Messung der dynamischen Reaktion (z.B. Impulsantwort) der Batterie auf Strompulse bei unterschiedlichen Ladungszuständen hilfreich sein, um Überspannungen zu erfassen. Die Dauer der Strompulse und die Dauer der anschließenden Pause hängt dabei vom Batterietyp, dem aktuellen Ladezustand und der Temperatur der Zelle ab. |

Als allgemeine Regel könnte im Rahmen von solchen Abhängigkeiten (vergleiche TAB. 4) auch ein jeweiliger Erwartungswert für die Genauigkeit der Schätzung des Gesundheitszustands berücksichtigt werden (d.h. ein Konfidenzwert). Das bedeutet, dass das Diagnose-Belastungsprofil unter der Berücksichtigung des jeweiligen Erwartungswert für die Genauigkeit der Schätzung des Gesundheitszustands bestimmt wird. beispielsweise ist in FIG. 4 für den Ladungszustand 20 % ein Toleranzbereich angegeben. Dieser Toleranzbereich könnte zum Beispiel mit einem vordefinierten Intervall für den Erwartungswert der Genauigkeit der Schätzung des Gesundheitszustands assoziiert sein. Zum Beispiel könnte bei Wahl der Zeitdauer des entsprechenden Betriebsblocks innerhalb des Toleranzbereichs eine Genauigkeit von mindestens 80 % einer optimalen Genauigkeit (durch die durchgezogene Linie indiziert) erhalten werden. Derart können also Toleranzen vorgesehen sein, die beispielsweise ausgenutzt werden können, wenn eine weitere Verkürzung der Diagnosezeit gewünscht ist.

Als allgemeine Regel könnte ein solcher Erwartungswert für die Genauigkeit der Schätzung des Gesundheitszustands aus den Referenz-Messungen für entsprechende Batterietypen erhalten werden. Beispielsweise könnte ein Schätzungsalgorithmus mit Hilfe von Messdaten aus Referenz-Messungen getestet und damit der Genauigkeitsbereich / Streuung der Algorithmen angegeben werden. Es gibt auch Schätzverfahren (Kalman-Filter, Neuronale Netze) die inhärent eine Genauigkeit der Schätzung ausgeben.

**In** solchen Szenarien ist es also möglich, dass das Diagnose-Belastungsprofil sowohl unter Berücksichtigung der Zeitdauer des Diagnose-Belastungsprofils bestimmt wird, wie auch unter Berücksichtigung der Genauigkeit des Diagnose-Belastungsprofils. Beispielsweise kann durch Ausnutzung von Toleranzen die Zeitdauer gezielt erhöht werden oder die Genauigkeit gezielt herabgesetzt werden.

Ausgehend von TAB. 4 ist ersichtlich, dass Szenarien auftreten können, bei denen Zielkonflikte vorliegen. Beispielsweise kann es in Anbetracht einer möglichst hohen Genauigkeit der Schätzung des Gesundheitszustands erstrebenswert sein, bestimmte Betriebsblöcke vorzusehen oder Betriebsblöcke auf bestimmte Art und Weise zu parametrisieren; während es in Anbetracht einer möglichst kurzen Diagnosezeit zielführend sein kann, diese Betriebsblöcke nicht vorzusehen oder anders zu parametrisieren. Als allgemeine Regel wäre es möglich, dass das Diagnose-Belastungsprofil unter Verwendung einer iterativen numerischen Optimierung bestimmt wird. Diese kann eine Zielfunktion aufweisen, die einerseits längere Diagnosezeiten bestraft und andererseits niedrigere Genauigkeiten der Schätzung des Gesundheitszustands bestraft. Das bedeutet also, dass der Zielkonflikt durch die Verwendung der iterativen numerischen Optimierung aufgelöst werden kann, indem sowohl eine besonders kurze Diagnosezeit, wie auch eine möglichst hohe Genauigkeit der Schätzung des Gesundheitszustands angestrebt wird. Iterativen numerischen Optimierung könnte zum Beispiel durch ein Gradientenabstiegsverfahren, einen Simplex-Optimierungsalgorithmus, oder genetische Algorithmen implementiert werden. Die Zielfunktion kann dabei unter Berücksichtigung von vorgegebenen Abhängigkeiten 800, wie sie obenstehend im Zusammenhang mit FIG. 4 oder TAB. 4 erläutert wurden, formuliert werden.

Mittels der voranstehenden Techniken ist es also möglich, durch die Typ-spezifische und Zustands-spezifische Bestimmung des Diagnose-Belastungsprofil eine verkürzte Diagnosezeit bei gleichzeitig hoher Güte der Schätzung des Alterungszustands zu ermöglichen. Insgesamt wurde festgestellt, dass hohe Güten der Schätzung des Alterungszustands auch dann erzielbar sind, wenn ein Teil-Laden oder Teil-Entladen der Batterie erfolgt.

Beispielweise kann es mittels der hierin beschriebenen Techniken entbehrlich sein, eine volle Entladung oder ein volles Laden der Batterie beim Anwenden des Diagnose-Belastungsprofils durchzuführen. Vielmehr kann eine Teilentladung oder ein Teilladen der Batterie durchgeführt werden. Das bedeutet, dass sich der Ladezustand (englisch SOC, state of charge) um einige Prozentpunkte verändern kann, insbesondere um weniger als 100 Prozentpunkte. Beispielsweise könnte der Ladezustand um weniger als 15 Prozentpunkte verändert werden, das heißt es könnte zum Beispiel ein Laden von 40 % SOC hinzu 55 % SOC durchgeführt werden (das bezeichnet einen Ladehub, ΔSOC). Dadurch kann die Diagnosezeit reduziert werden. Allgemein könnte der Ladehub kleiner/gleich 50 Prozentpunkte sein, optional kleiner/gleich 20 Prozentpunkte, weiter optional kleiner/gleich 15 Prozentpunkt.

Eine solche verkürzte Diagnosezeit ermöglicht spezifische Anwendungsszenarien. Beispielsweise kann im Zusammenhang mit einer technischen Eignungsprüfung von Kraftfahrzeugen - hierbei ist typischerweise die Zeit pro Kraftfahrzeug stark begrenzt, um genügend Kraftfahrzeuge zu überprüfen - der Gesundheitszustand der Traktions-Batterien geschätzt werden, wenn die Kraftfahrzeuge an einen Prüfstand angeschlossen werden. Ein entsprechendes Anwendungsszenario ist nachfolgend im Zusammenhang mit FIG. 5 beschrieben.FIG. 5 ist ein Signalfluss-Diagramm, welches die Kommunikation zwischen einem Prüfstand 91, den ein elektrisches Kraftfahrzeug 90 angeschlossen ist, einem Benutzerterminal 93 (z.B. ein Computer oder Laptop), das von einem Benutzer 92 bedient, einem Server 94 und einer Datenbank 95 illustriert. Die Kommunikation gemäß FIG. 5 kann zum Beispiel das Verfahren aus FIG. 3 implementieren.

Im dargestellten Beispiel implementiert der Server 94 die Logik zum Bestimmen des Diagnose-Belastungsprofils (Box 5025) sowie zum Bestimmen des Gesundheitszustands (Box 5055). Der Server 94 kann einen entsprechenden Dienst für eine Vielzahl von Prüfständen bereitstellen.

Z.B. kann der Server 94 über das Internet mit dem Benutzerterminal 93 verbunden sein und das Benutzerterminal 93 kann über eine lokale Netzwerkverbindung mit dem Prüfstand 91 verbunden sein. Der Prüfstand 91 kann über eine Diagnoseverbindung mit einem BMS der Traktionsbatterie des Elektrofahrzeugs 90 verbunden sein, etwa über ein Fahrzeug-Bussystem.

Durch die Verwendung des Prüfstands 91 wird ermöglich, ein genau spezifiziertes Diagnose-Belastungsprofil vorzugeben. Im Realverkehr wären lediglich indirekte Vorgaben möglich (z.B. Stillstand an gewissen Punkten, Vorgabe von Sollgeschwindigkeiten).

Zunächst erfolgt das Setup 5005 (Initialisierung) einer Diagnose-Verbindung zwischen dem Prüfstand 91 und dem Benutzerterminal 93, wenn das Kraftfahrzeug 90 an den Prüfstand 91 angeschlossen wird und wenn ein entsprechendes Diagnose-Protokoll vom Benutzer 92 am Benutzerterminal 93 initiiert wird. Zum Beispiel kann der Prüfstand 91 über ein Fahrzeug-Bussystem Daten mit einem Batterie-Managementsystem der Traktionsbatterie des Kraftfahrzeugs 90 austauschen. Im Rahmen des Setup 5005 können Zustandsdaten 81 und Typdaten 82 an das Benutzerterminal 93 übertragen werden.

Die Typdaten könnten zumindest teilweise auch vom Benutzer 92 am Benutzerterminal 93 eingegeben werden. Der Nutzer wählt z.B. das Fahrzeugmodell inkl. Batterietyp und -größe aus.

Dann können in Box 5006 ein oder mehrere Randbedingungen für die Zustandsdaten 81 bestimmt werden, zum Beispiel basierend auf den Typdaten 82. Es kann überprüft werden, ob der Zustand der Traktionsbatterie kompatibel ist mit den ein oder mehreren Randbedingungen.

Zum Beispiel könnte überprüft werden, ob ein bestimmter minimaler Ladungszustand oder ob ein bestimmter maximaler Ladungszustand unterschritten bzw. überschritten wird. Ein solcher minimaler Ladungszustand oder maximaler Ladungszustand kann je nach Batterietyp unterschiedlich gewählt sein. Es könnte überprüft werden, ob die Betriebstemperatur der Batterie in einem bestimmten vorgegebenen Bereich ist. Es könnte überprüft werden, ob zuvor eine vorgegebene minimale Ruhezeit eingehalten wurde.

Mittels Box 5006 kann also eine Vorprüfung erfolgen, ob der Zustand der Traktionsbatterie des Elektrofahrzeugs 90 grundsätzlich geeignet ist, um eine schnelle Schätzung des Gesundheitszustands zu ermöglichen.

Bei erfolgreicher Überprüfung in Box 5006 kann dann eine Anfrage 5010 an den Server 94 gesendet werden. Die Anfrage 5010 beinhaltet die Zustandsdaten 81 und die Typdaten 82.

Während im illustrierten Beispiel der FIG. 5 die Zustandsdaten 81 und die Typdaten 82 vom Benutzerterminal 93 an den Server 94 übertragen werden, wäre es im Allgemeinen auch möglich, dass die Zustandsdaten 81 und die Typdaten 82 direkt vom Prüfstand 91 an den Server 94 übertragen werden.

Der Server 94 kann dann eine entsprechende Anfrage 5015 an die Datenbank 95 stellen. Es ist optional möglich, dass diese Anfrage 5015 auf die Zustandsdaten 81 und/oder die Typdaten 82 umfasst.

Dann wird eine Nachricht 5020 von der Datenbank 95 an den Server 94 übermittelt, welche indikativ für ein oder mehrere Referenzen ist. Zum Beispiel könnten vorgegebene Abhängigkeiten, wie voranstehend im Zusammenhang mit FIG. 4 und TABs. 3 und 4 diskutiert, übertragen werden.

In Box 5025 kann dann das Diagnose-Belastungsprofil bestimmt werden. Dabei können Referenzen gemäß Nachricht 5020 berücksichtigt werden.

Das Diagnose-Belastungsprofil kann dann mit einer Nachricht 5026 an den Prüfstand 91 übertragen werden, beispielsweise direkt vom Server 94 oder über das Benutzerterminal 93.

Der Prüfstand 91 wendet dann das Diagnose-Belastungsprofil über einen bestimmten Zeitraum an, was in FIG. 5 mit dem Bezugszeichen 5028 gekennzeichnet ist. Es ist möglich, dass der Prüfstand 91 mehrfach Messdaten in entsprechenden Nachrichten 5030 an den Server 94 übermittelt. Die Messdaten sind indikativ für ein Spannungsprofil und ein Stromprofil des Belastungsvorgangs der Traktionsbatterie des Fahrzeugs 90, der durch das Diagnose-Belastungsprofil bewirkt wird.

In FIG. 5 ist ein Szenario dargestellt, in dem die Messdaten bereits vor Abschluss des Diagnose-Belastungsprofil an den Server 94 übermittelt werden. Derart ist es möglich, in Box 5035 optional die Messdaten während des Anwendens des Diagnose-Belastungsprofil zu überwachen und mittels einer entsprechenden Nachricht 5040 das Diagnose-Belastungsprofil basierend auf dem Überwachen der Messdaten anzupassen. Beispielsweise kann es basierend auf den "Vorab"-Messdaten ersichtlich werden, dass weitere Betriebsblöcke des Belastungsprofil benötigt werden, um eine zuverlässige Schätzung des Gesundheitszustands durchzuführen. Dann könnte das Diagnose-Belastungsprofil ad hoc verlängert werden, indem die Nachricht 5040 gesendet wird. Das Überwachen der Messdaten kann insbesondere das Überwachen einer Abweichung von Spannungswerten des Spannungsprofils zwischen unterschiedlichen Batteriezellen der Traktionsbatterie umfassen. Solche Techniken beruhen auf der Erkenntnis, dass eine Abweichung zwischen den Spannungsprofil der unterschiedlichen Batteriezellen indikativ für eine unterschiedlich fortgeschrittene Alterung der verschiedenen Batteriezellen sein kann. In solchen Szenarien ist es typischerweise erforderlich, differenziertere Messdaten zu erfassen, welche eine Aufschlüsselung des Gesundheitszustands für die unterschiedlichen Batteriezellen der Batterie ermöglichen. Beispielsweise könnte ein entsprechender Betriebsblock des Diagnose-Belastungsprofils, der eine weitergehende Differenzierung zwischen unterschiedlichen Batteriezellen ermöglicht, wahlweise aktiviert werden, wenn die Messdaten eine entsprechende Abweichung zwischen Spannungswerten für unterschiedliche Batteriezellen indizieren.

In verschiedenen Varianten wäre es denkbar, dass der Schätzungsalgorithmus zur Bestimmung der Schätzung des Gesundheitszustands der Traktionsbatterie des Fahrzeugs 90 fest im Server 94 hinterlegt ist. Das bedeutet, dass unabhängig vom Typ der Batterie und/oder unabhängig vom Zustand der Batterie jeweils derselbe Schätzungsalgorithmus verwendet werden kann.

In anderen Beispielen wäre es aber auch denkbar, dass, zum Beispiel in Abhängigkeit der Typ Daten und/oder der Zustandsdaten, ein Schätzungsalgorithmus aus mehreren Kandidaten-Schätzungsalgorithmen ausgewählt wird. In dem Szenario der FIG. 5 sendet dazu der Server 94 eine entsprechende Anfrage 5045 an die Datenbank 95. Die Datenbank 95 sendet dann eine Nachricht 5050, die den konkreten Schätzungsalgorithmus indiziert. Die Anfrage 5045 könnte zum Beispiel die Typdaten 82 beinhalten.

Solche Techniken beruhen auf der Erkenntnis, dass manchmal nicht für alle Typen von Batterien bestimmte präferierte Typen von Schätzungsalgorithmen vorhanden sind, z.B. weil diese noch nicht geeignet Parametrisiert wurden (vgl. FIG. 2: Box 6005). Beispielsweise könnte ein maschinengelerntes Modell nur für manche Batterietypen vorhanden sein, weil noch kein entsprechendes Training stattgefunden hat. Wenn kein speziell signiertes maschinengelerntes Modell verfügbar ist, kann ein allgemeiner Schätzungsalgorithmus eingesetzt werden, der grundsätzlich möglicherweise eine geringere Genauigkeit bereitstellt.

In Box 5055 wird dann die Schätzung des Gesundheitszustands bestimmt, unter Verwendung des entsprechenden Schätzungsalgorithmus. Es könnten auch mehrere Schätzungsalgorithmen kombiniert werden. Die Ergebnisse könnten dann verglichen werden. Das kann die Genauigkeit erhöhen.

Das Ergebnis der Schätzung kann mit einer Nachricht 5060 an das Benutzerterminal 93 übermittelt werden. Das Ergebnis der Diagnose kann an den Benutzer 94 ausgegeben werden.

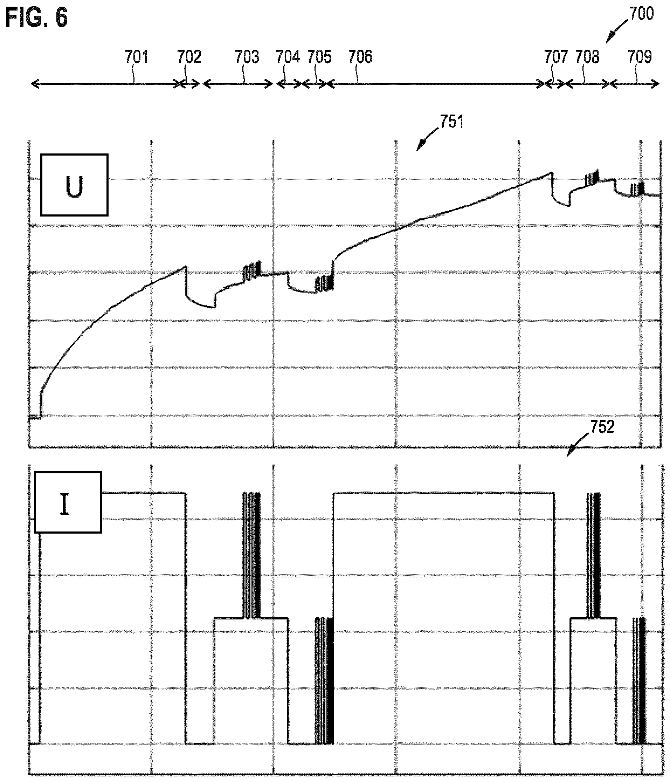

FIG. 6 illustriert Aspekte im Zusammenhang mit einem beispielhaften Diagnose-Belastungsprofil 700. Das Diagnose-Belastungsprofil 700 umfasst mehrere Betriebsblöcke 701-709 (vgl. TAB. 1). Während des Betriebsblocks 701 wird ein konstanter Stromfluss verwendet, um die Batterie zu laden. Es folgt eine Ruhephase in Betriebsblock 702. Im Betriebsblock 703 wird ein variabler Stromfluss verwendet. Es folgt eine weitere Ruhephase in Block 704. Anschließend werden Strompulse im Betriebsblock 705 angewendet. Die Blöcke 706-709 entsprechen dann einer Wiederholung der Blöcke 701-705.

In FIG. 6 sind auch entsprechende Messdaten für das Spannungsprofil 751 und das Stromprofil 752 dargestellt.

Zusammenfassend wurden voranstehend also Techniken beschrieben, welche eine Erfassung von Messdaten zur Schätzung eines Gesundheitszustands innerhalb kurzer Zeit ermöglichen. Es wurden Techniken beschrieben, die in Werkstätten, Fahrtauglichkeits-Centern während Reparaturen oder während der Eignungsuntersuchung ausgeführt werden können. Es ist lediglich ein einzelner Teilladevorgang erforderlich. Die Sicherstellung von vergleichbaren Untersuchungsbedingungen während der Datenaufzeichnung (im Fahrbetrieb nicht oder nur mit hohem Aufwand mit Rollenprüfstand) ist möglich.

Selbstverständlich können die Merkmale der vorab beschriebenen Ausführungsformen und Aspekte der Erfindung miteinander kombiniert werden. Insbesondere können die Merkmale nicht nur in den beschriebenen Kombinationen, sondern auch in anderen Kombinationen oder für sich genommen verwendet werden, ohne das Gebiet der Erfindung zu verlassen.

Beispielsweise wurden voranstehend Techniken beschrieben, bei denen ein Diagnose-Belastungsprofil basierend auf Zustandsdaten und basierend auf Typdaten einer Traktionsbatterie bestimmt wird. Alternativ oder zusätzlich könnten auch andere oder weitere Entscheidungskriterien beim Bestimmen des Diagnose-Belastungsprofil berücksichtigt werden. Zum Beispiel wäre es denkbar, dass eine Benutzereingabe berücksichtigt wird. Zum Beispiel könnte der Benutzer eine gewünschte Spannung, gewünschte Leistung, gewünschte Batterieladung oder gewünschte Batterie-Temperatur vorgeben, die als Basis für die Schätzung des Gesundheitszustandes dienen soll. Dann kann das Diagnose-Belastungsprofil so bestimmt werden, dass Messdaten jeweils bei dem entsprechenden Sollwert erfasst werden. Ein weiterer Aspekt beträfe das Erhalten von Zustandsdaten des Prüfstands. Beispielsweise könnte der Prüfstand eine Umgebungstemperatur des Kraftfahrzeugs signalisieren. Die Umgebungstemperatur könnte bei der Bestimmung des Diagnose-Belastungsprofil berücksichtigt werden.

Ferner wurden voranstehend Techniken beschrieben, bei denen ein Belastungs-Diagnoseprofil zum Laden der Traktionsbatterie verwendet wird. Es wäre entsprechend möglich, ein Belastungs-Diagnoseprofil zum Entladen der Traktionsbatterie zu verwenden. Auch kombiniertes Laden und Entladen wäre denkbar.

Ferner wurden Aspekte im Zusammenhang mit dem Bestimmen des Gesundheitszustands für Traktions-Batterien von Elektrofahrzeugen beschrieben. Allgemein wäre es aber möglich, die entsprechenden Techniken auch für andere Typen von Batterien bzw. andere Anwendungsszenarien einzusetzen. Beispielsweise wäre es denkbar, die hierin beschriebenen Techniken für Batterien in stationären Energiespeicher-Anlagen einzusetzen. Auch in einem solchen Anwendungsszenario kann es erstrebenswert sein, den Normalbetrieb nur kurzfristig zu unterbrechen, das bedeutet, die Diagnosezeit möglichst kurz zu dimensionieren.

## Patentansprüche

1. Computer-implementiertes Verfahren, wobei das Verfahren umfasst:
- Erhalten von Typdaten (82) und Zustandsdaten (81) einer Traktionsbatterie eines Elektrofahrzeugs (90), die an einen Prüfstand (91) angeschlossen ist,
- basierend auf den Typdaten (82) und basierend auf den Zustandsdaten (81), Bestimmen eines Diagnose-Belastungsprofils (700), das mehrere Betriebsblöcke (701-709) umfasst, die mit unterschiedlichen Belastungsszenarien assoziiert sind,
- Ansteuern des Prüfstands (91) zum Anwenden des Diagnose-Belastungsprofils (700), um derart Messdaten für ein Spannungsprofil (751) und ein Stromprofil (752) eines Belastungsvorgangs der Traktionsbatterie zu erhalten, und
- Bestimmen einer Schätzung eines Gesundheitszustands der Traktionsbatterie basierend auf den Messdaten.

2. Computer-implementiertes Verfahren nach Anspruch 1,
wobei das Bestimmen des Diagnose-Belastungsprofils (700) zumindest eines der folgenden Elemente umfasst:
Auswählen der mehreren Betriebsblöcke (701-709) aus einer Vielzahl von mehreren vordefinierten Betriebsblöcken;
Bestimmen einer Abfolge der mehreren Betriebsblöcke (701-709); und/oder
Parametrisieren von ein oder mehreren Parametern von mindestens einem Betriebsblock der mehreren Betriebsblöcke (701-709), wobei die ein oder mehreren Parameter des mindestens einen Betriebsblocks ausgewählt sind aus einer Gruppe, die umfasst: Dauer des entsprechenden Betriebsblocks;
Entladungs- oder Laderate eines Entladungs- oder Ladestroms; Ladehub; Amplitude eines Strompulses.

3. Computer-implementiertes Verfahren nach Anspruch 1 oder 2,
wobei das Diagnose-Belastungsprofil basierend auf ein oder mehreren vorgegebenen Abhängigkeiten (800) zwischen Parametern des Diagnose-Belastungsprofils (700) und den Zustandsdaten (81) und/oder den Typdaten (82) bestimmt werden,
wobei die ein oder mehreren vorgegebenen Abhängigkeiten basierend auf Referenz-Messungen bestimmt sind, die physikalisch-chemische Eigenschaften des jeweiligen Batterietyps erfassen.

4. Computer-implementiertes Verfahren nach Anspruch 3,
wobei die Schätzung mittels eines Schätzungsalgorithmus bestimmt wird,
wobei die ein oder mehreren vorgegebenen Abhängigkeiten basierend auf Trainings-Messdaten, die zum Parametrisieren des Schätzungsalgorithmus verwendet werden, bestimmt sind.

5. Computer-implementiertes Verfahren nach Anspruch 3 oder 4,
wobei die ein oder mehreren vorgegebenen Abhängigkeiten (800) mit Erwartungswerten für eine Genauigkeit der Schätzung des Gesundheitszustands assoziiert sind,
wobei das Diagnose-Belastungsprofil unter Berücksichtigung der Erwartungswerte für die Genauigkeit der Schätzung des Gesundheitszustands bestimmt wird.

6. Computer-implementiertes Verfahren nach einem der voranstehenden Ansprüche,
wobei das Diagnose-Belastungsprofil unter Berücksichtigung einer Zeitdauer des Diagnose-Belastungsprofils (700) und/oder einer Genauigkeit der Schätzung des Gesundheitszustands bestimmt wird,
wobei das Diagnose-Belastungsprofil unter Verwendung einer iterativen numerischen Optimierung bestimmt wird, die eine Zielfunktion berücksichtigt, die längere Zeitdauern des Diagnose-Belastungsprofils (700) bestraft und niedrigere Genauigkeiten der Schätzung des Gesundheitszustands bestraft.

7. Computer-implementiertes Verfahren nach einem der voranstehenden Ansprüche, wobei das Verfahren weiterhin umfasst:
- während des Anwendens des Diagnose-Belastungsprofils (700), Überwachen der Messdaten und wahlweise Anpassen eines verbleibenden Teils des Diagnose-Belastungsprofils (700) basierend auf dem Überwachen der Messdaten,
wobei das Überwachen der Messdaten das Überwachen einer Abweichung von Spannungswerten des Spannungsprofils zwischen unterschiedlichen Batteriezellen der Traktionsbatterie umfasst.

8. Computer-implementiertes Verfahren nach einem der voranstehenden Ansprüche, wobei das Verfahren weiterhin umfasst:
- basierend auf den Typdaten (82), Auswählen eines Schätzungsalgorithmus aus mehreren Kandidaten-Schätzungsalgorithmen,
wobei die Schätzung mittels des ausgewählten Schätzungsalgorithmus bestimmt wird.

9. Computer-implementiertes Verfahren nach einem der voranstehenden Ansprüche,
wobei das Bestimmen des Diagnose-Belastungsprofils (700) und das Bestimmen der Schätzung des Gesundheitszustands von einem zentralen Server (94) ausgeführt wird, der mit einer Vielzahl von Prüfständen (91) verbunden ist, wobei die Vielzahl von Prüfständen (91) den Prüfstand (91) umfasst.

10. Computer-implementiertes Verfahren nach einem der voranstehenden Ansprüche, wobei das Verfahren weiterhin umfasst:
- Bestimmen von ein oder mehreren Randbedingungen für die Zustandsdaten (81) und Überprüfen, ob der Zustand der Batterie kompatibel mit den ein oder mehreren Randbedingungen ist,
wobei die ein oder mehreren Randbedingungen basierend auf den Typdaten (82) bestimmt werden.

11. Computer-implementiertes Verfahren nach einem der voranstehenden Ansprüche,
wobei das Diagnose-Belastungsprofil eine Teilladung der Batterie definiert, welche einen Ladungszustand der Batterie um nicht mehr als 15 Prozentpunkte erhöht.

12. Computer-implementiertes Verfahren nach einem der voranstehenden Ansprüche, wobei das Verfahren weiterhin umfasst:
- Erhalten von weiteren Zustandsdaten (81) des Prüfstands (91),
wobei das Diagnose-Belastungsprofil weiterhin basierend auf den weiteren Zustandsdaten (81) bestimmt wird.

13. Computer-implementiertes Verfahren nach einem der voranstehenden Ansprüche,
wobei das Bestimmen des Diagnose-Belastungsprofils umfasst: basierend auf einem Ladungszustand der Traktionsbatterie, der durch die Zustandsdaten angezeigt wird, Bestimmen einer Ladungszustands-Differenz des Ladungszustands, wobei die Ladungszustands-Differenz zwischen einem Beginn und einem Ende des Diagnose-Belastungsprofils durch Anwenden des Diagnose-Belastungsprofils bewirkt wird.

14. Computer-implementiertes Verfahren nach einem der voranstehenden Ansprüche,
wobei das Bestimmen des Diagnose-Belastungsprofils umfasst: basierend auf einem Ladungszustand und/oder einer Temperatur der Traktionsbatterie, die durch die Zustandsdaten angezeigt werden, Bestimmen einer Dauer eine Ladephase des Diagnose-Belastungsprofils.

15. Computerprogramm, das Programmcode umfasst, wobei Ausführen des Programmcodes durch einen Prozessor bewirkt, dass der Prozessor das Verfahren ausführt, das umfasst:
- Erhalten von Typdaten (82) und Zustandsdaten (81) einer Traktionsbatterie eines Elektrofahrzeugs (90), die an einen Prüfstand (91) angeschlossen ist,
- basierend auf den Typdaten (82) und basierend auf den Zustandsdaten (81), Bestimmen eines Diagnose-Belastungsprofils (700), das mehrere Betriebsblöcke (701-709) umfasst, die mit unterschiedlichen Belastungsszenarien assoziiert sind,
- Ansteuern des Prüfstands (91) zum Anwenden des Diagnose-Belastungsprofils (700), um derart Messdaten für ein Spannungsprofil (751) und ein Stromprofil (752) eines Belastungsvorgangs der Traktionsbatterie zu erhalten, und
- Bestimmen einer Schätzung eines Gesundheitszustands der Traktionsbatterie basierend auf den Messdaten.

## Claims

1. Computer-implemented method, the method comprising:
- obtaining type data (82) and state data (81) of a traction battery of an electric vehicle (90) connected to a test bench (91),
- based on the type data (82) and based on the state data (81), determining a diagnostic load profile (700) comprising multiple operational blocks (701-709) associated with different load scenarios,
- actuating the test bench (91) to apply the diagnostic load profile (700) so as to obtain measurement data for a voltage profile (751) and a current profile (752) of a loading process of the traction battery, and
- determining an estimate of a state of health of the traction battery based on the measurement data.

2. Computer-implemented method according to claim 1,
wherein determining the diagnostic load profile (700) comprises at least one of the following:
selecting the multiple operational blocks (701-709) from a plurality of multiple predefined operational blocks;
determining a sequence of the multiple operational blocks (701-709); and/or
parameterizing one or more parameters of at least one operational block of the multiple operational blocks (701-709), wherein the one or more parameters of the at least one operational block are selected from a group comprising: duration of the corresponding operational block; discharge or charge rate of a discharge or charge current; charging stroke; amplitude of a current pulse.

3. Computer-implemented method according to claim 1 or 2,
wherein the diagnostic load profile is determined based on one or more predetermined dependencies (800) between parameters of the diagnostic load profile (700) and the state data (81) and/or the type data (82),
wherein the one or more predetermined dependencies are determined based on reference measurements that detect physicochemical properties of the respective battery type.

4. Computer-implemented method according to claim 3,
wherein the estimate is determined by means of an estimation algorithm,
wherein the one or more predetermined dependencies are determined based on training measurement data used to parameterize the estimation algorithm.

5. Computer-implemented method according to claim 3 or 4,
wherein the one or more predetermined dependencies (800) are associated with expected values for accuracy of the estimate of the state of health,
wherein the diagnostic load profile is determined by taking into account the expected values for the accuracy of the estimate of the state of health.

6. Computer-implemented method according to any one of the preceding claims,
wherein the diagnostic load profile is determined by taking into account a time period of the diagnostic load profile (700) and/or an accuracy of the estimate of the state of health,
wherein the diagnostic load profile is determined using an iterative numerical optimization that takes into account a target function that penalizes longer time periods of the diagnostic load profile (700) and penalizes lower accuracies of estimate of the state of health.

7. Computer-implemented method according to any one of the preceding claims, wherein the method further comprises:
- while applying the diagnostic load profile (700), monitoring the measurement data and optionally adjusting a remaining portion of the diagnostic load profile (700) based on monitoring the measurement data,
wherein monitoring the measurement data comprises monitoring a deviation of voltage values of the voltage profile between different battery cells of the traction battery.

8. Computer-implemented method according to any one of the preceding claims, wherein the method further comprises:
- based on the type data (82), selecting an estimation algorithm from a plurality of candidate estimation algorithms,
wherein the estimate is determined using the selected estimation algorithm.

9. Computer-implemented method according to any one of the preceding claims,
wherein determining the diagnostic load profile (700) and determining the estimate of state of health is performed by a central server (94) connected to a plurality of test benches (91), the plurality of test benches (91) comprising the test bench (91).

10. Computer-implemented method according to any one of the preceding claims, wherein the method further comprises:
- determining one or more boundary conditions for the state data (81) and checking whether the state of the battery is compatible with the one or more boundary conditions,
wherein the one or more boundary conditions are determined based on the type data (82).

11. Computer-implemented method according to any one of the preceding claims,
wherein the diagnostic load profile defines a partial charge of the battery that increases a state of charge of the battery by no more than 15 percentage points.

12. Computer-implemented method according to any one of the preceding claims, wherein the method further comprises:
- obtaining further state data (81) of the test bench (91),
wherein the diagnostic load profile is further determined based on the further state data (81).

13. Computer-implemented method according to any one of the preceding claims,
wherein determining the diagnostic load profile comprises: based on a state of charge of the traction battery indicated by the state data, determining a state-of-charge difference of the state of charge, wherein the state-of-charge difference between a beginning and an end of the diagnostic load profile is caused by applying the diagnostic load profile.

14. Computer-implemented method according to any one of the preceding claims,
wherein determining the diagnostic load profile comprises: based on a state of charge and/or a temperature of the traction battery indicated by the state data, determining a duration of a charging phase of the diagnostic load profile.

15. Computer program comprising program code, wherein the execution of the program code by a processor causes the processor to perform the method comprising:
- obtaining type data (82) and state data (81) of a traction battery of an electric vehicle (90) connected to a test bench (91),
- based on the type data (82) and based on the state data (81), determining a diagnostic load profile (700) comprising multiple operational blocks (701-709) associated with different load scenarios,
- actuating the test bench (91) to apply the diagnostic load profile (700) so as to obtain measurement data for a voltage profile (751) and a current profile (752) of a loading process of the traction battery, and
- determining an estimate of a state of health of the traction battery based on the measurement data.

## Revendications

1. Procédé mis en œuvre sur ordinateur, le procédé comprenant :
- obtention des données de type (82) et données d'état (81) d'une batterie de traction d'un véhicule électrique (90) raccordée à un banc d'essai (91),
- sur la base des données de type (82) et sur la base des données d'état (81), détermination d'un profil de charge de diagnostic (700) comprenant plusieurs blocs opérationnels (701-709) associés à différents scénarios de charge,
- actionnement du banc d'essai (91) pour appliquer le profil de charge de diagnostic (700) afin d'obtenir des données de mesure pour un profil de tension (751) et un profil de courant (752) d'un processus de charge de la batterie de traction, et
- détermination d'une estimation de l'état de santé de la batterie de traction sur la base des données de mesure.

2. Procédé mis en œuvre sur ordinateur selon la revendication 1,
dans lequel la détermination du profil de charge de diagnostic (700) comprend au moins l'un des éléments suivants :
sélection de plusieurs blocs opérationnels (701-709) parmi une multitude de plusieurs blocs opérationnels prédéfinis ;
détermination d'une séquence de plusieurs blocs opérationnels (701-709) ; et/ou
paramétrage d'un ou plusieurs paramètres d'au moins un bloc opérationnel de plusieurs blocs opérationnels (701-709), les uns ou plusieurs paramètres d'au moins un bloc opérationnel étant choisis dans un groupe comprenant : durée du bloc opérationnel correspondant ; taux de décharge ou de charge d'un courant de décharge ou de charge ; course de chargement ; amplitude d'une impulsion de courant.

3. Procédé mis en œuvre sur ordinateur selon la revendication 1 ou 2,
dans lequel le profil de charge de diagnostic est déterminé sur la base d'une ou plusieurs dépendances prédéterminées (800) entre les paramètres du profil de charge de diagnostic (700) et les données d'état (81) et/ou les données de type (82),
dans lequel l'une ou plusieurs dépendances prédéterminées sont déterminées sur la base de mesures de référence qui acquièrent les propriétés physico-chimiques du type de batterie respectif.

4. Procédé mis en œuvre sur ordinateur selon la revendication 3,
dans lequel l'estimation est déterminée à l'aide d'un algorithme d'estimation,
dans lequel l'une ou plusieurs dépendances prédéterminées sont déterminées sur la base des données de mesure d'entraînement utilisées pour paramétrer l'algorithme d'estimation.

5. Procédé mis en œuvre sur ordinateur selon la revendication 3 ou 4,
dans lequel l'une ou plusieurs dépendances prédéterminées (800) sont associées à des valeurs attendues pour une précision de l'estimation de l'état de santé,
dans lequel le profil de charge de diagnostic est déterminé en tenant compte des valeurs attendues pour la précision de l'estimation de l'état de santé.

6. Procédé mis en œuvre sur ordinateur selon l'une quelconque des revendications précédentes,
dans lequel le profil de charge de diagnostic est déterminé en tenant compte d'une période temporelle du profil de charge de diagnostic (700) et/ou d'une précision de l'estimation de l'état de santé,
dans lequel le profil de charge de diagnostic est déterminé à l'aide d'une optimisation numérique itérative en tenant compte une fonction cible qui pénalise les périodes temporelles plus longues du profil de charge de diagnostic (700) et pénalise les précisions inférieures de l'estimation de l'état de santé.

7. Procédé mis en œuvre sur ordinateur selon l'une quelconque des revendications précédentes, le procédé comprenant en outre :
- lors de l'application du profil de charge de diagnostic (700), la surveillance des données de mesure et éventuellement l'adaptation d'une partie restante du profil de charge de diagnostic (700) sur la base de la surveillance des données de mesure,
dans lequel la surveillance des données de mesure comprend la surveillance d'une déviation des valeurs de tension du profil de tension entre les différentes cellules de la batterie de traction.

8. Procédé mis en œuvre sur ordinateur selon l'une quelconque des revendications précédentes, le procédé comprenant en outre :
- sur la base des données de type (82), sélection d'un algorithme d'estimation parmi =- plusieurs algorithmes d'estimation candidats,
dans lequel l'estimation est déterminée à l'aide de l'algorithme d'estimation sélectionné.

9. Procédé mis en œuvre sur ordinateur selon l'une quelconque des revendications précédentes,
dans lequel la détermination du profil de charge de diagnostic (700) et la détermination de l'estimation de l'état de santé sont effectuées par un serveur central (94) connecté à une pluralité de bancs d'essai (91), la pluralité de bancs d'essai (91) comprenant le banc d'essai (91).

10. Procédé mis en œuvre sur ordinateur selon l'une quelconque des revendications précédentes, le procédé comprenant en outre :
- détermination d'une ou plusieurs conditions limites pour les données d'état (81) et vérification que l'état de la batterie est compatible avec l'une ou plusieurs conditions limites,
dans lequel les une ou plusieurs conditions limites sont déterminées sur la base des données de type (82).

11. Procédé mis en œuvre sur ordinateur selon l'une quelconque des revendications précédentes,
dans lequel le profil de charge de diagnostic définit un chargement partiel de la batterie qui n'augmente pas l'état de chargement de la batterie de plus de 15 points de pourcentage.

12. Procédé mis en œuvre sur ordinateur selon l'une quelconque des revendications précédentes, le procédé comprenant en outre :
- obtention d'autres données d'état (81) du banc d'essai (91),
dans lequel le profil de charge de diagnostic est toujours déterminé sur la base des autres données d'état (81).

13. Procédé mis en œuvre sur ordinateur selon l'une quelconque des revendications précédentes,
dans lequel la détermination du profil de charge de diagnostic comprend : sur la base d'un état de chargement de la batterie de traction indiqué par les données d'état, la détermination d'une différence d'état de chargement de l'état de chargement, la différence d'état de chargement entre un début et une fin du profil de charge de diagnostic étant effectuée en appliquant le profil de charge de diagnostic.

14. Procédé mis en œuvre sur ordinateur selon l'une quelconque des revendications précédentes,
dans lequel la détermination du profil de charge de diagnostic comprend : sur la base d'un état de chargement et/ou d'une température de la batterie de traction indiquée par les données d'état, la détermination d'une durée d'une phase de chargement du profil de charge de diagnostic.

15. Programme informatique comprenant un code de programme, dans lequel l'exécution du code de programme par un processeur provoque l'exécution par le processeur de la procédure comprenant :
- obtention des données de type (82) et données d'état (81) d'une batterie de traction d'un véhicule électrique (90) raccordée à un banc d'essai (91),
- sur la base des données de type (82) et sur la base des données d'état (81), détermination d'un profil de charge de diagnostic (700) comprenant plusieurs blocs opérationnels (701-709) associés à différents scénarios de charge,
- actionnement du banc d'essai (91) pour appliquer le profil de charge de diagnostic (700) afin d'obtenir des données de mesure pour un profil de tension (751) et un profil de courant (752) d'un processus de charge de la batterie de traction, et
- détermination d'une estimation de l'état de santé de la batterie de traction sur la base des données de mesure.
